# EUROPEAN PATENT APPLICATION

(11) **EP 4 525 057 A1**
(43) Date of publication of application: **19.03.2025**
(21) Application number: 22959031.0
(22) Date of filing: 20.09.2022
(51) Int. Cl.: H01L 31/048

(54) **SOLAR CELL ASSEMBLY AND PREPARATION METHOD THEREFOR, CELL AND PREPARATION TOOL**

(71) Applicant: Contemporary Amperex Future Energy Research Institute (Shanghai) Limited, Shanghai 200241 (CN)
(72) Inventor: CHEN, Chen, Shanghai 200241 (CN); CHEN, Junchao, Shanghai 200241 (CN); GUO, Yongsheng, Shanghai 200241 (CN); CHEN, Guodong, Shanghai 200241 (CN)
(74) Representative: Ran, Handong
(86) International application number: PCT/CN2022/119946
(87) International publication number: WO 2024/060019

(57) **Abstract**

Provided in the present application are a solar cell assembly and a preparation method therefor, a cell, and a preparation tool. In a conductive layer preparation process, several conductive layers separated by means of first trenches are formed in a substrate; and after the conductive layers are formed, functional layer groups formed on one side of the conductive layers are separated on two sides of second separating members and third separating members by means of the separation function of the second separating members and the third separating members, and the functional layer groups come into contact with the conductive layers by means of the spaces occupied by the second separating members on the conductive layers, so that the different functional layer groups are connected in series. Therefore, there is no need to perform additional laser scribing on the formed structure, which effectively solves the problem of increased series resistance caused by conventional scribing that is too shallow or too deep, so as to ensure the performance stability of the solar cell assembly.

## Description

### TECHNICAL FIELD

This application relates to the field of solar cell technologies, and in particular, to a solar cell assembly and a preparation method thereof, a battery, and a preparation tooling.

### BACKGROUND

A solar cell assembly refers to a device that converts light energy into electric power by using the photovoltaic effect, including several sub-cells distributed at intervals. Each sub-cell includes a conductive layer, a functional layer group, and an electrode layer that are stacked together. For two adjacent sub-cells, a series connection is achieved through the electrode layer of one sub-cell and the conductive layer of another sub-cell. The functional layer group includes a first transport layer, a semiconductor layer, and a second transport layer stacked in sequence.

During the preparation process, laser scribing is typically used to achieve the series connection of sub-cells within the assembly, for example, P1 scribing, which cuts the conductive layer; P2 scribing, which cuts the semiconductor layer and the upper and lower transport layers to allow the metal electrode layer to come into contact with the conductive layer; and P3 scribing, which disconnects two adjacent sub-cells.

However, laser scribing not only has a complex process, but also tends to increase the series resistance between sub-cells, thereby reducing the device performance.

### SUMMARY

Based on this, it is necessary to provide a solar cell assembly and a preparation method thereof, a battery, and a preparation tooling to simplify the battery preparation process and ensure the performance stability of the solar cell assembly.

According to a first aspect, this application provides a preparation method of a solar cell assembly, including the following steps: providing a substrate; forming conductive layers on the substrate separated by a first trench along a preset direction; arranging an isolation body on a side of the conductive layer facing away from the substrate, where the isolation body includes a second separating member and a third separating member that are arranged side by side and are integrated or separable; sequentially stacking and depositing a first transport layer, a semiconductor layer, and a second transport layer on at least one side of the isolation body along the preset direction; and removing the isolation body and separately inserting a new third separating member; or removing the second separating member and retaining the third separating member in the isolation body, and depositing an electrode layer on one side of the second transport layer.

In the foregoing preparation method of the solar cell assembly, during the process of preparing the conductive layer, several conductive layers separated by the first trench are formed on the substrate. After the conductive layers are formed, the separating function of the second separating members and the separating function of the third separating members are respectively utilized to ensure that the functional layer groups (the functional layer group includes the first transport layer, semiconductor layer, and second transport layer stacked in sequence) formed on one side of the conductive layers are separated by and located on two sides of the second separating members and the third separating members. In addition, the space occupied by the second separating member on the conductive layer allows the electrode layer to come into contact with the conductive layer through this space, thereby achieving the series connection of different sub-cells. Thus, in this application, the separating function of the second separating members and the third separating members is utilized to ensure that at least two scribe lines on the solar cell assembly are formed during their respective forming processes, eliminating the need for additional laser scribing on a formed structure. This effectively addresses the issue of traditional scribing being too shallow or too deep, which leads to increased series resistance, thereby ensuring the performance stability of the solar cell assembly.

In some embodiments, the step of forming conductive layers on the substrate separated by a first trench along a preset direction includes: arranging a first separating member on the substrate, and depositing on two sides of the first separating member along the preset direction to form conductive layers separated by the first trench. Thus, disconnected conductive layers are formed using the first separating member without the need for laser or mechanical scribing, which is conducive to ensuring stable performance of the assembly.

In some embodiments, the step of arranging a first separating member on the substrate, and depositing conductive layers on two sides of the first separating member along the preset direction includes: arranging several first separating members at intervals on the substrate along the preset direction; sputtering on a side surface of the substrate facing the first separating members in a vacuum environment; and removing the first separating members to leave first trenches on the substrate, thereby forming several conductive layers. Such design not only simplifies the forming process of the conductive layer but also ensures mutual disconnection between the formed conductive layers, avoiding the need for laser or mechanical scribing.

In some embodiments, the step of arranging an isolation body on a side of the conductive layer facing away from the substrate includes: simultaneously arranging the second separating member and the third separating member, which are attached to each other, on a side of each of at least part of the conductive layers facing away from the substrate. In this design, the second separating member and the third separating member are arranged on at least part of the conductive layers, separating the first transport layer, semiconductor layer, and second transport layer; and when the second separating member is removed, a second trench is left, which ensures that the electrode layer gets in contact with the conductive layer to achieve a series connection, making the preparation of the solar cell assembly more convenient.

In some embodiments, the step of simultaneously arranging the second separating member and the third separating member, which are attached to each other, on a side of each of at least part of the conductive layers facing away from the substrate includes: simultaneously arranging the second separating member and the third separating member on each conductive layer along the preset direction except for conductive layers located at two ends of the substrate, and controlling each second separating member to be adjacent to a first side of a corresponding first trench, and the third separating member to be located on a side of the second separating member facing away from the first trench adjacent to the second separating member. Such design ensures that the functional layer group in the middle part meets the structural forming requirements, making the solar cell assembly have good voltage and current output.

In some embodiments, a distance between the second separating member and the adjacent first trench is denoted as D, satisfying 0 µm (micrometer) < D ≤ 20 µm. Controlling the distance between the second separating member and the adjacent first trench within a reasonable range is conducive to obtaining a more reasonable structure and more stable performance of the assembly.

In some embodiments, the step of simultaneously arranging the second separating member and the third separating member, which are attached to each other, on a side of each of at least part of the conductive layers facing away from the substrate further includes: on a conductive layer located at one end of the substrate and on a first side of the first trench, arranging the second separating member and controlling the second separating member to be adjacent to the corresponding first trench; and on a conductive layer located at another end of the substrate and on a second side of the first trench, arranging the third separating member and controlling the third separating member to be spaced apart from the corresponding first trench, where the first side and the second side face opposite directions. Such design ensures that the specifications of the sub-cell at one end meet the design requirements, and also ensures that the electrode layer of the sub-cell at the another end gets in contact with the conductive layer, making the structure and performance of the solar cell assembly more stable.

In some embodiments, the step of sequentially stacking and depositing a first transport layer, a semiconductor layer, and a second transport layer on two sides of an overall structure of the second separating member and the third separating member along the preset direction includes: sequentially depositing the first transport layer, the semiconductor layer, and the second transport layer on the side of the conductive layer facing away from the substrate in a vacuum environment. In this design, the first transport layer, the semiconductor layer, and the second transport layer are deposited on the side of the conductive layer facing away from the substrate in a vacuum environment, making the obtained assembly performance better; and meanwhile, through the utilization of the second separating member and the third separating member, disconnected semiconductor layers are automatically obtained without subsequent laser or mechanical scribing.

In some embodiments, the step of sequentially stacking and depositing a first transport layer, a semiconductor layer, and a second transport layer on at least one side of the isolation body along the preset direction further includes: on at least one of conductive layers located at two ends of the substrate along the preset direction, shielding one side edge of the conductive layer facing away from the substrate and away from the first trench. Thus, before depositing the functional layer group, shielding one side edge of the conductive layer near one end of the substrate for each of the two ends avoids the deposition of the functional layer group on the edge, thereby avoiding the subsequent edge cleaning process.

In some embodiments, thickness of the second separating member and thickness of the third separating member along the preset direction both range from 50 µm to 200 µm. Thus, reasonably controlling the thickness of the second separating member and the thickness of the third separating member is conducive to obtaining second trenches and third trenches of reasonable thickness, avoiding excessively wide trenches that reduce the effective working area of the assembly.

In some embodiments, the semiconductor layer is a perovskite layer. In this design, the preparation method of this application enables a perovskite cell assembly to be prepared quickly and effectively, and additionally, it is conducive to improving the yield rate of the perovskite cell assembly.

According to a second aspect, this application provides a solar cell assembly, prepared by using any of the foregoing preparation methods of the solar cell assembly.

According to a third aspect, this application provides a battery, including the foregoing solar cell assembly.

According to a fourth aspect, this application provides a preparation tooling, applied to any of the foregoing preparation methods of the solar cell assembly, including: a first auxiliary mechanism, including several first separating members penetrating through a first frame body having a first cavity and arranged in parallel at intervals in the first cavity; a second auxiliary mechanism, including several isolation bodies penetrating through a second frame body having a second cavity and arranged in parallel at intervals in the second cavity, the isolation bodies being configured to be respectively located on same sides of their corresponding first separating members, where the isolation body includes a second separating member and a third separating member arranged side by side; and a third auxiliary mechanism, including several third separating members penetrating through a third frame body having a third cavity and arranged in parallel at intervals in the third cavity, distribution positions of the third separating members in the third cavity being consistent with distribution positions of the third separating members in the second cavity.

In the foregoing preparation tooling, during the preparation of the conductive layers, the substrate is placed in the first cavity, so that several first separating members are distributed at intervals on the substrate, ensuring that the conductive layers are disconnected during the forming process, avoiding the need for laser or other tools for scribing after the forming process. After the conductive layers are formed, the substrate with the conductive layers is placed in the second cavity, so that the isolation bodies are distributed at intervals on one side of the conductive layers, making functional layer groups formed on one side of the conductive layers be separated on two sides of the third separating members. The space occupied by the second separating member on the conductive layer is utilized to make the functional layer group come into contact with the conductive layer through this space, achieving a series connection of different functional layer groups. This effectively addresses the issue of traditional scribing being too shallow or too deep, which leads to increased series resistance, thereby ensuring the performance stability of the solar cell assembly.

In some embodiments, the first auxiliary mechanism further includes two first supporting members spaced apart in the first cavity, each first separating member connecting the two first supporting members. Thus, through the arrangement of the two first supporting members, the fixation of the first separating member is more stable, which is conducive to improving the precision of the deposition of the conductive layer.

In some embodiments, the first separating member, the second separating member, and the third separating member are all configured as a flat structure, and a flat surface of the first separating member is parallel to a penetration direction of the first cavity, a flat surface of the second separating member is parallel to a penetration direction of the second cavity, and a flat surface of the third separating member is parallel to a penetration direction of the second cavity or the third cavity. This flat design reduces the space each thickness occupies in the corresponding cavity, avoiding reducing the effective working area of the assembly.

In some embodiments, the first supporting member is located in the first cavity, forming a first groove between the first supporting member and one end surface of the first cavity, the first groove being configured for placing the substrate. Such design makes the fixation of the substrate more convenient, thereby making the deposition of the conductive layer more stable.

In some embodiments, when the second frame body is stacked on the first frame body, for the isolation body and a corresponding first separating member, the second separating member is located between the first separating member and the third separating member, and a distance between the second separating member and the corresponding first separating member is denoted as D, satisfying 0 µm < D ≤ 20 µm. In this design, the distribution positions of the first separating member, the second separating member, and the third separating member are reasonably controlled, which is conducive to obtaining a more reasonable structure and more stable performance of the assembly.

In some embodiments, the second auxiliary mechanism further includes two second supporting members spaced apart in the second cavity, each second separating member connecting the two second supporting members. Thus, through the arrangement of the two second supporting members, the fixation of the second separating member is more stable, which is conducive to improving the precision of the deposition of the functional layer group.

In some embodiments, the second supporting member is located in the second cavity, forming a second groove between the second supporting member and one end surface of the second cavity, the second groove being configured for placing the substrate with a conductive layer. Such design makes the fixation of the substrate with a conductive layer more convenient, thereby making the deposition of the functional layer group more stable.

In some embodiments, the second auxiliary mechanism further includes two shielding members which are spaced apart and connect the two second supporting members, the two shielding members being located on two sides of all the isolation bodies and respectively fitting with inner walls of the second cavity. Arrangement of the shielding members on two sides of the isolation bodies is conducive to shielding the deposition of the functional layer group on the edges, avoiding deposition on two ends of the substrate that would require subsequent edge cleaning processes.

In some embodiments, the second auxiliary mechanism further includes a separate second separating member and a separate third separating member, the separate second separating member and the separate third separating member being respectively located on two opposite sides of all the isolation bodies. Such design is conducive to ensuring that the specifications of the sub-cell at one end meets the design requirements, and also ensures that the electrode layer of the sub-cell at the another end gets in contact with the conductive layer, making the structure and performance of the solar cell assembly more stable.

The foregoing description is merely an overview of the technical solution of this application. For a better understanding of the technical means in this application such that they can be implemented according to the content of the specification, and to make the above and other objectives, features and advantages of this application more obvious and easier to understand, the following describes specific embodiments of this application.

### BRIEF DESCRIPTION OF DRAWINGS

Persons of ordinary skill in the art can clearly understand various other advantages and benefits by reading the detailed description of the preferred embodiments below. The accompanying drawings are merely intended to illustrate the preferred embodiments and are not intended to limit this application. Moreover, throughout the accompanying drawings, the same reference signs represent the same parts. In the accompanying drawings:
FIG. 1 is a first flowchart of preparing a solar cell assembly according to some embodiments of this application;
FIG. 2 is a schematic structural diagram of the middle part of a solar cell assembly according to some embodiments of this application;
FIG. 3 is a schematic structural diagram of a first auxiliary mechanism according to some embodiments of this application;
FIG. 4 is a schematic structural diagram of cooperation between a substrate and a conductive layer according to some embodiments of this application;
FIG. 5 is a schematic structural diagram of a second auxiliary mechanism according to some embodiments of this application;
FIG. 6 is a second flowchart of preparing a solar cell assembly according to some embodiments of this application;
FIG. 7 is a third flowchart of preparing a solar cell assembly according to some embodiments of this application;
FIG. 8 is a schematic structural diagram of a solar cell assembly not deposited with an electrode layer according to some embodiments of this application;
FIG. 9 is a schematic structural diagram of a third auxiliary mechanism according to some embodiments of this application;
FIG. 10 is a fourth flowchart of preparing a solar cell assembly according to some embodiments of this application;
FIG. 11 is a schematic diagram showing a structure at two ends of a solar cell assembly according to some embodiments of this application;
FIG. 12 is a schematic diagram of distribution of first separating members according to some embodiments of this application;
FIG. 13 is a schematic diagram of distribution of second separating members and third separating members according to some embodiments of this application;
FIG. 14 is a schematic diagram of distribution of third separating members according to some embodiments of this application; and
FIG. 15 is a fifth flowchart of preparing a solar cell assembly according to some embodiments of this application.

100. solar cell assembly; 10. substrate; 20. conductive layer; 21. first trench; 30. functional layer group; 31. first transport layer; 32. semiconductor layer; 33. second transport layer; 34. electrode layer; 35. second trench; 36. third trench; 200. preparation tooling; 210. first auxiliary mechanism; 211. first cavity; 212. first separating member; 213. first supporting member; 214. first frame body; 215. first gap; 220. second auxiliary mechanism; 221. second cavity; 222. isolation body; 22a. second separating member; 22b. third separating member; 223. second supporting member; 224. shielding member; 225. second frame body; 226. second gap; 230. third auxiliary mechanism; 231. third cavity; 232. third frame body; 233. third gap; and X. preset direction.

### DESCRIPTION OF EMBODIMENTS

The following describes in detail the embodiments of technical solutions of this application with reference to the accompanying drawings. The following embodiments are merely intended for a clearer description of the technical solutions of this application and therefore are used as just examples which do not constitute any limitations on the protection scope of this application.

Unless otherwise defined, all technical and scientific terms used herein shall have the same meanings as commonly understood by those skilled in the art to which this application belongs. The terms used herein are merely intended to describe the specific embodiments but not intended to constitute any limitation on this application. The terms "include", "have", and any other variations thereof in the specification, the claims and the foregoing brief description of drawings of this application are intended to cover a non-exclusive inclusion.

In descriptions of embodiments of this application, the technical terms "first", "second" and the like are merely intended to distinguish between different objects, and shall not be understood as any indication or implication of relative importance or any implicit indication of the number, specific sequence or primary-secondary relationship of the technical features indicated. In the description of the embodiments of this application, "a plurality of" means at least two unless otherwise specifically stated.

In this specification, reference to "embodiment" means that specific features, structures or characteristics described with reference to the embodiment may be incorporated in at least one embodiment of this application. The word "embodiment" appearing in various places in the specification does not necessarily refer to the same embodiment or an independent or alternative embodiment that is exclusive of other embodiments. Persons skilled in the art explicitly and implicitly understand that the embodiments described herein may be combined with other embodiments.

In the descriptions of the embodiments of this application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the description of the embodiments of this application, the term "a plurality of" means more than two (inclusive). Similarly, "a plurality of groups" means more than two (inclusive) groups, and "a plurality of pieces" means more than two (inclusive) pieces.

In the description of the embodiments of this application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", " radial", "circumferential", and the like are based on the orientations or positional relationships as shown in the accompanying drawings. These terms are merely for ease and brevity of description of the embodiments of this application rather than indicating or implying that the means or components mentioned must have specific orientations or must be constructed or manipulated according to specific orientations, and therefore shall not be construed as any limitation on the embodiments of this application.

In the description of the embodiments of this application, unless otherwise specified and defined explicitly, the terms "mount", "connect", "join", and "fasten" should be understood in their general senses. For example, they may refer to a fixed connection, a detachable connection, or an integral connection, may refer to a mechanical connection or electrical connection, and may refer to a direct connection, an indirect connection via an intermediate medium, or an interaction between two elements. Persons of ordinary skill in the art can understand specific meanings of these terms in this application as appropriate to specific situations.

With the development of science, breakthroughs in the development of new energy sources have been continuously achieved. For example, solar cells represented by perovskite and organic thin-film cells have made disruptive progress, and such solar cells, due to their high efficiency and low cost advantages, are expected to replace silicon-based solar cells.

For solar cell assemblies, to obtain suitable voltage and current output, scribing is often performed through laser or mechanical scribing to achieve the division and series connection of sub-cells. For example, after a conductive layer is deposited on the substrate, the first scribing is performed by using laser or mechanical scribing to complete the division of the sub-cells. Next, the first transport layer, the semiconductor layer, and the second transport layer are deposited; then, the second scribing is performed by using laser or mechanical scribing to complete the trench scribing for series connection of the sub-cells. Finally, the top electrode film layer is deposited; then, the third scribing is performed by using laser or mechanical scribing to complete the division of the front electrode.

The applicant has noticed that during the performing of the second scribing, if the scribing energy is too low, the transport layer and the semiconductor layer cannot be cut through, leading to the residual transport layer or semiconductor layer. This prevents the electrode layer from directly getting in contact with the conductive layer, and the electrode layer may come into contact with, for example, SnO₂ in the transport layer. This greatly increases the contact resistance, severely affecting the performance of the assembly. If the scribing energy is too high, the conductive layer may easily be cut, also causing an increase in the series resistance between sub-cells, thereby reducing the performance of the assembly.

Based on this, to solve the problem that traditional laser or mechanical scribing easily increases the series resistance between sub-cells and reduces the performance of the solar cell assembly, after in-depth research, the applicant has designed a preparation method of a solar cell assembly. This method utilizes the shielding of the second separating member and the third separating member to form the first transport layer, semiconductor layer, and second transport layer on two sides of the second separating member and the third separating member on a side of the conductive layer facing away from the substrate. Then, after the second separating member is removed, by utilizing the shielding of the old or new third separating member, disconnected electrode layers are formed on one side of the second transport layer.

In the foregoing preparation method of a solar cell assembly, during the preparation of the conductive layer, several conductive layers separated by first trenches are formed on the substrate; after the conductive layers are formed, the separating function of the second separating member and the separating function of the third separating member are respectively utilized to make functional layer groups formed on one side of the conductive layer be separated on two sides of the second separating members and the third separating members; and then, after the second separating member is removed, the space occupied by the second separating member on the conductive layer is utilized to make the electrode layer come into contact with the conductive layer through this space, achieving series connection of different sub-cells. Thus, in this application, the separating function of the first separating members, the second separating members, and the third separating members is utilized to ensure that at least three scribe lines on the solar cell assembly are formed during their respective forming processes, eliminating the need for additional laser scribing on a formed structure. This effectively addresses the issue of traditional scribing being too shallow or too deep, which leads to increased series resistance, thereby ensuring the performance stability of the solar cell assembly.

It should be noted that during the deposition process, for example, sputtering, evaporation processes, and the like, considering the adhesion and spreading properties of each layer of material, to better remove the second separating member and the third separating member from the deposited layer structure, pretreatment can be performed on the second separating member and the third separating member respectively, for example, cleaning off impurities such as grease and dust on the second separating member and the third separating member; or coating a release agent on the second separating member and the third separating member.

The solar cell assembly disclosed in this application may be but is not limited to a perovskite cell assembly, an organic thin-film cell assembly, and the like; and of course, it may also be a silicon-based cell assembly, and the like. In addition, the battery disclosed in this application may be used for, but is not limited to, electric apparatuses such as vehicles, ships, or aircrafts. The battery, and the like disclosed in this application may be used to constitute a power supply system of that electric apparatus.

An embodiment of this application provides an electric apparatus that uses a battery as a power source. The electric apparatus may be but is not limited to a mobile phone, a tablet, a laptop computer, an electric toy, an electric tool, an electric bicycle, an electric car, a ship, a spacecraft, a space station, and the like. The electric toys may include fixed or mobile electric toys, for example, game consoles, electric toy cars, electric toy ships, and electric toy airplanes.

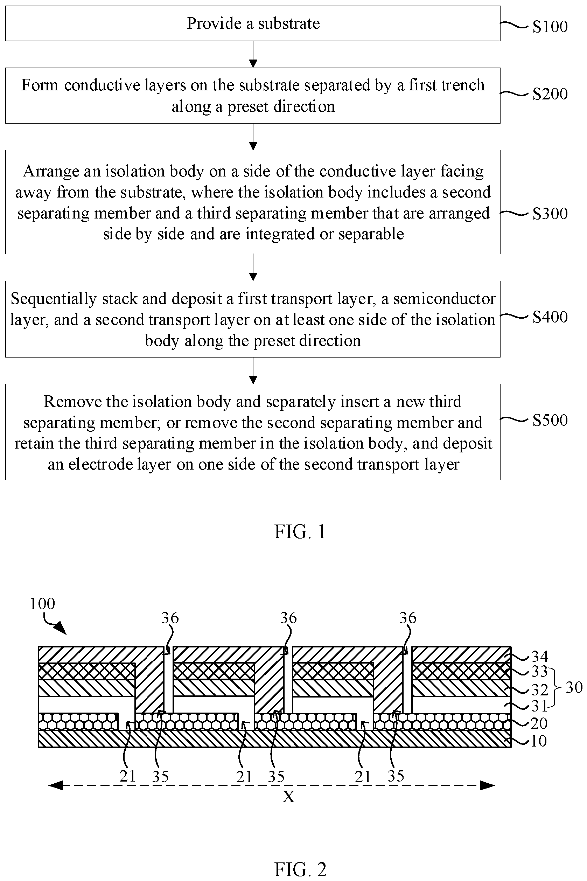

According to some embodiments of this application, referring to FIG. 1 and FIG. 2, this application provides a preparation method of a solar cell assembly 100, including the following steps:
S100: Provide a substrate 10;
S200: Form conductive layers 20 on the substrate 10 separated by a first trench 21 along a preset direction X;
S300: Arrange an isolation body 222 on a side of the conductive layer 20 facing away from the substrate 10, where the isolation body 222 includes a second separating member 22a and a third separating member 22b that are arranged side by side and are integrated or separable;
S400: Sequentially stack and deposit a first transport layer 31, a semiconductor layer 32, and a second transport layer 33 on at least one side of the isolation body 222 along the preset direction X; and
S500: Remove the isolation body 222 and separately insert a new third separating member 22b; or remove the second separating member 22a and retain the third separating member 22b in the isolation body 222, and deposit an electrode layer 34 on one side of the second transport layer 33.

The substrate 10 is also referred to as a base plate or base. A material of the substrate 10 may be but is not limited to glass, tempered glass, quartz, organic flexible materials, and the like. Of course, it may also be transparent conductive glass, stainless steel conductive flexible bases, polyethylene glycol terephthalate (polyethylene glycol terephthalate, PET) conductive flexible bases, and the like.

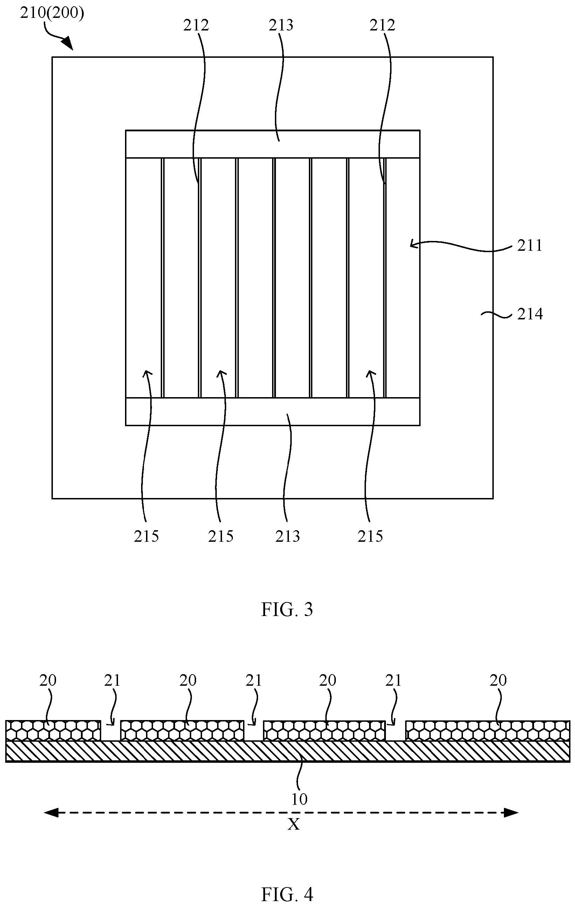

In step S200, during the formation of the conductive layer 20, referring to FIG. 3 and FIG. 4, due to the separation by first trenches 21, the conductive layers 20 are formed to be disconnected. A first trench 21 refers to a spatial structure that can separate the conductive layers 20 and can extend on the substrate 10 in a direction perpendicular to the preset direction X. A cross-sectional shape of the first trench 21 may be of various types, for example, it may be, but is not limited to, semi-circular, semi-elliptical, rectangular, and the like.

The formation of the first trench 21 may be achieved in various ways. For example, the first trench 21 may be formed on the substrate 10 by laser or mechanical scribing, meaning that during the separation of the conductive layer 20, laser or mechanical methods are used for scribing. Alternatively, a separating structure may be pre-arranged on the substrate 10, and during the forming process of the conductive layer 20, the shielding of the separating structure may be used to leave a groove-like structure, and the like on the substrate 10.

The second separating member 22a and the third separating member 22b refer to components with certain structural strength, which act as partition structures during the forming process of the conductive layer 20 or the functional layer group 30, making the conductive layer 20 or the functional layer group 30 being formed be separated by the corresponding separating members.

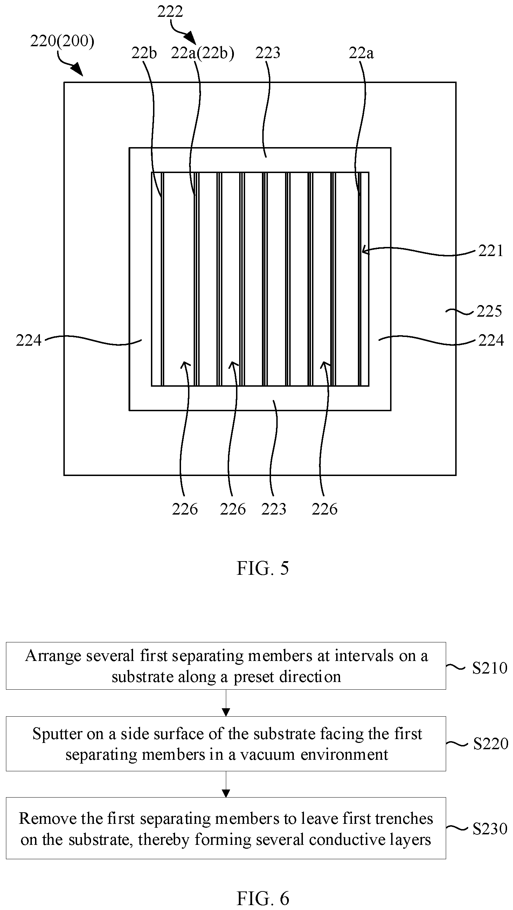

The second separating member 22a and the third separating member 22b should be as thin as possible; if their respective thicknesses are too thick, it will cause the gap between the conductive layers 20 and the gap between the functional layer groups 30 to be too large, reducing the effective working area of the solar cell assembly 100, thereby affecting the performance of the device. Therefore, both the second separating member 22a and the third separating member 22b are in a plate-like or sheet-like structure as a whole. During the preparation process, referring to FIG. 2 and FIG. 5, removing the second separating member 22a will form a second trench 35 between the semiconductor layers 32; and removing the third separating member 22b will form a third trench 36 between the functional layer groups 30. The second trench 35 can provide corresponding space for the subsequent contact between the electrode layer 34 and the conductive layer 20.

The second separating member 22a and the third separating member 22b in the isolation body 222 may be designed as an integrated structure, in other words, the second separating member 22a and the third separating member 22b are inseparable; and of course, the second separating member 22a and the third separating member 22b in the isolation body 222 may alternatively be designed as a separable structure, for example, the two are fixed on a same structure by snapping. When the second separating member 22a and the third separating member 22b are designed as an integrated structure, the second separating member 22a and the third separating member 22b are fixedly connected, such as by bonding and integrated molding, where the integrated molding may be injection molding, die casting, extrusion, and the like. Additionally, if the second separating member 22a and the third separating member 22b are designed as an integrated structure, the second separating member 22a and the third separating member 22b may be regarded as a whole structure.

When the isolation body 222 is arranged on the conductive layer 20, the second separating member 22a and the third separating member 22b are distributed side by side along the preset direction X.

The conductive layer 20 may be a transparent conductive oxide (transparent conductive oxide, abbreviated as TCO) film, which has an average transmittance of over 80% in the visible light range (wavelength 380 (nanometer) nm to 760 nm, corresponding to energy 3.26 eV (electronvolt) to 1.63 eV), with high conductivity and resistivity lower than 1×10⁻³ Ω·cm (ohm-centimeter). There are various material choices for it, such as, but not limited to, indium doped tin oxide (indium doped tin oxide, ITO), fluorine doped tin oxide (fluorine doped tin oxide, FTO), and aluminum doped zinc oxide (aluminum doped zinc oxide, AZO), and the like.

The functional layer group 30 refers to a core structure in the solar cell assembly 100, which can convert absorbed light energy into electrical energy, including the first transport layer 31, the semiconductor layer 32, and the second transport layer 33. The first transport layer 31 and the second transport layer 33 refer to the layer structures stacked on two sides of the semiconductor, mainly playing the role of transporting electrons or holes. The first transport layer 31 may be an electron transport layer, and the second transport layer 33 may be a hole transport layer; in this case, the solar cell assembly 100 is of the nip type (normal structure); or the first transport layer 31 may be a hole transport layer, and the second transport layer 33 may be an electron transport layer; in this case, the solar cell assembly 100 is of the pin type (inverted structure). The electron transport layer, in addition to transporting electrons, also serves to block holes. There are various material choices for this layer, such as TiO₂, ZnO, SnO₂, or organic materials, and the like. The hole transport layer, in addition to transporting holes, also serves to block electrons. Its material may be, but is not limited to, spiro-OMeTAD, PTAA (poly[bis(4-phenyl)(2,4,6-trimethylphenyl)amine]), NiO_{X}, and the like.

The semiconductor layer 32 refers to a structure that excites electron/hole pairs when absorbing light energy, such as a perovskite layer, a silicon wafer layer, and the like. The electrode layer 34, also known as the metal electrode layer 34, back cathode, and the like. Its material may be but is not limited to Ag, Au, Pt, Cu, and the like.

It should be noted that the sub-cell mentioned in this application may be understood as a structure formed by vertically stacking the conductive layer 20, the first transport layer 31, the semiconductor layer 32, the second transport layer 33, and the electrode layer 34. Of course, it can also be understood as a combined structure of the functional layer group 30 and the electrode layer 34.

Removing the second separating member 22a means that after the first transport layer 31, the semiconductor layer 32, and the second transport layer 33 are deposited, the second separating member 22a is removed, which is equivalent to the traditional second scribing process, forming a second trench 35 between the first transport layers 31, the semiconductor layers 32, and the second transport layers 33. Thereafter, when the electrode layer 34 is being deposited, the electrode layer 34 will partially be deposited in the second trench 35 to achieve contact with the conductive layer 20.

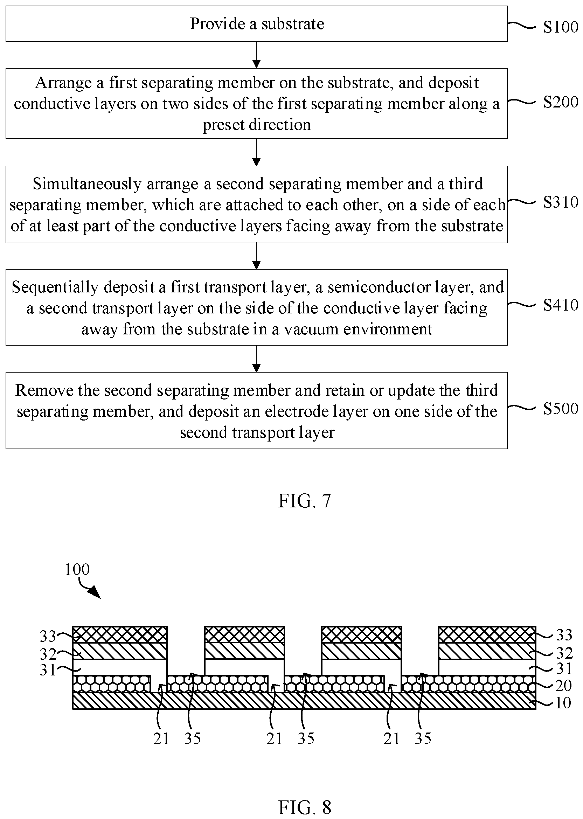

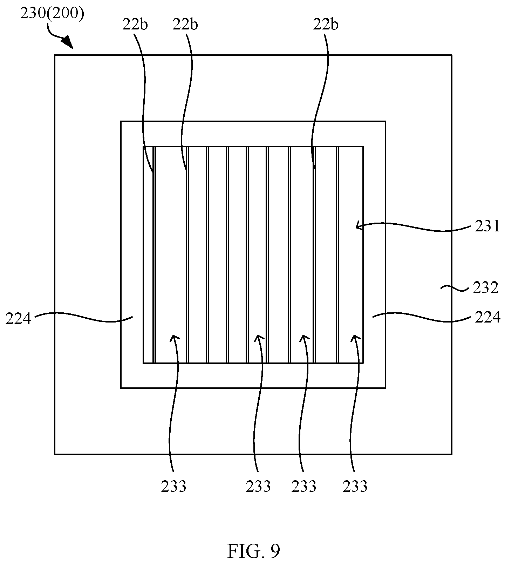

Referring to FIG. 8, removing the isolation body 222 and separately inserting a new third separating member 22b, and removing the second separating member 22a and retaining the third separating member 22b in the isolation body 222 refer to two different operations. Retaining the third separating member 22b means that the original third separating member 22b remains in place at its original position. In this case, the second separating member 22a and the third separating member 22b are separable. However, inserting a new third separating member 22b means that while removing the second separating member 22a, the third separating member 22b is also removed, and then the new third separating member 22b is placed in the corresponding position. Referring to FIG. 9, in this case, the second separating member 22a and the old third separating member 22b are connected to each other and may be regarded as an integrated structure. Refer to FIG. 5.

During the forming process of the solar cell assembly 100, the second separating member 22a and the third separating member 22b both provide a separating function. For example, the second separating member 22a and the third separating member 22b jointly separate the first transport layers 31, the semiconductor layers 32, and the second transport layers 33. After the second separating member 22a is removed, a second trench 35 is formed on one side of the conductive layer 20, where the second trench 35 is utilized to make the subsequent electrode layer 34 to come into contact with the conductive layer 20.

The separating function of the second separating members 22a and the third separating members 22b is utilized to ensure that at least two scribe lines on the solar cell assembly 100 are formed during their respective forming processes, eliminating the need for additional laser scribing on a formed structure. This effectively addresses the issue of traditional scribing being too shallow or too deep, which leads to increased series resistance, thereby ensuring the performance stability of the solar cell assembly 100.

According to some embodiments of this application, the step S200 further includes:
arranging a first separating member 212 on the substrate 10, and depositing on two sides of the first separating member 212 along the preset direction X to form conductive layers 20 separated by the first trench 21.

Arranging the first separating member 212 on the substrate 10 makes at least a part of a region on the substrate 10 be shielded by the first separating member 212, so that this part of the region cannot be deposited to form the conductive layer 20, thereby making several conductive layers 20 formed on the substrate 10 be spaced apart along the preset direction X.

Since the temperature during the forming process of the conductive layer 20 is higher than the temperature during other forming processes, the material selection for the first separating member 212 should consider its ability to withstand a certain temperature, such as plastics like polyphenylene sulfide (Polyphenylene sulfide, abbreviated as PPS). Of course, metal materials can also be used.

Using the first separating member 212 to form disconnected conductive layers 20 eliminates the need for laser or mechanical scribing, which is conducive to ensuring the performance stability of the assembly.

According to some embodiments of this application, referring to FIG. 6, the step of arranging a first separating member 212 on the substrate 10, and depositing on two sides of the first separating member 212 along the preset direction X to form conductive layers 20 separated by the first trench 21 includes:
S210: Arrange several first separating members 212 on the substrate 10 along the preset direction X at intervals;
S220: Sputter on a side surface of the substrate 10 facing the first separating members 212 in a vacuum environment; and
S230: Remove the first separating members 212 to leave first trenches 21 on the substrate 10, thereby forming several conductive layers 20.

It can be seen that during the forming process of the conductive layer 20, several first separating members 212 are arranged on the substrate 10 along the preset direction X, so that the substrate 10 is not sputtered to form the conductive layers 20 at the positions where the first separating members 212 are located, thereby making the formed conductive layers 20 be separated. Refer to FIG. 4 for details.

The first separating members 212 may be arranged on the substrate 10 in various ways. For example, several first separating members 212 may be directly placed and fixed on the surface of the substrate 10; alternatively, several first separating members 212 may be fixed together through a frame body in advance to form a mold structure, and then the mold is fitted on the substrate 10.

When several first separating members 212 are arranged at intervals, it can ensure that a distance between two adjacent first separating members 212 remains consistent, so the sizes of the formed conductive layers 20 can also remain consistent.

The sputtering of the conductive layer 20 refers to magnetron sputtering technology. For example, under the action of an electric field, electrons are accelerated toward the substrate 10, and in this process, electrons collide with argon atoms, ionizing a large number of argon ions and electrons. The electrons fly toward the substrate 10. Argon ions, accelerated under the electric field, bombard the target material, sputtering a large number of target atoms. These neutral target atoms (or molecules) then deposit on the substrate 10 to form a film. During the sputtering process, a vacuum environment refers to maintaining the vacuum degree of the working environment at a certain value during the sputtering deposition of the conductive layer 20. For example, the vacuum degree of the vacuum environment may be but is not limited to 10⁻³ (Pa) Pa to 10⁻⁴ Pa, and the like.

Such design not only simplifies the forming process of the conductive layer 20 but also ensures mutual disconnection between the formed conductive layers 20, avoiding the need for scribing using laser or mechanical means.

According to some embodiments of this application, referring to FIG. 7, the step S300 of arranging a second separating member 22a and a third separating member 22b side by side on a side of the conductive layer 20 facing away from the substrate 10 includes:
S310: Simultaneously arrange the second separating member 22a and the third separating member 22b, which are attached to each other, on a side of each of at least part of the conductive layers 20 facing away from the substrate 10.

Simultaneously arranging the second separating member 22a and the third separating member 22b on at least part of the conductive layers 20 should be understood as: during the preparation process of the first transport layer 31, the semiconductor layer 32, and the second transport layer 33, for example, part of the conductive layers 20 are arranged with both the second separating member 22a and the third separating member 22b, and part of the conductive layers 20 may be arranged with only the second separating member 22a or the third separating member 22b; and all the conductive layers 20 are arranged with both the second separating member 22a and the third separating member 22b.

The first transport layer 31, the semiconductor layer 32, and the second transport layer 33 may be deposited in various methods, such as evaporation, sputtering, vapor transport method, close-space sublimation method, and the like. Among them, evaporation refers to a process in which the coating material (or film material) is heated and evaporated in a certain way to gasify it under vacuum conditions. The particles fly to the surface of the substrate plate to condense into a film. Due to the operation under vacuum conditions, water and oxygen can be prevented from affecting the performance of the assembly. During the evaporation process, the vacuum environment refers to maintaining the vacuum degree of the working environment at a certain value when the evaporation deposition is performed. For example, the vacuum degree of the vacuum environment may be but is not limited to less than or equal to 10⁻³ Pa, and the like.

With such a design, the second separating member 22a and the third separating member 22b are arranged on at least part of the conductive layers 20, separating the first transport layers 31, the semiconductor layers 32, and the second transport layers 33. Removing the second separating member 22a leaves the second trench 35, ensuring contact between the electrode layer 34 and the conductive layer 20, thereby achieving series connection. This makes the preparation of the solar cell assembly 100 more convenient.

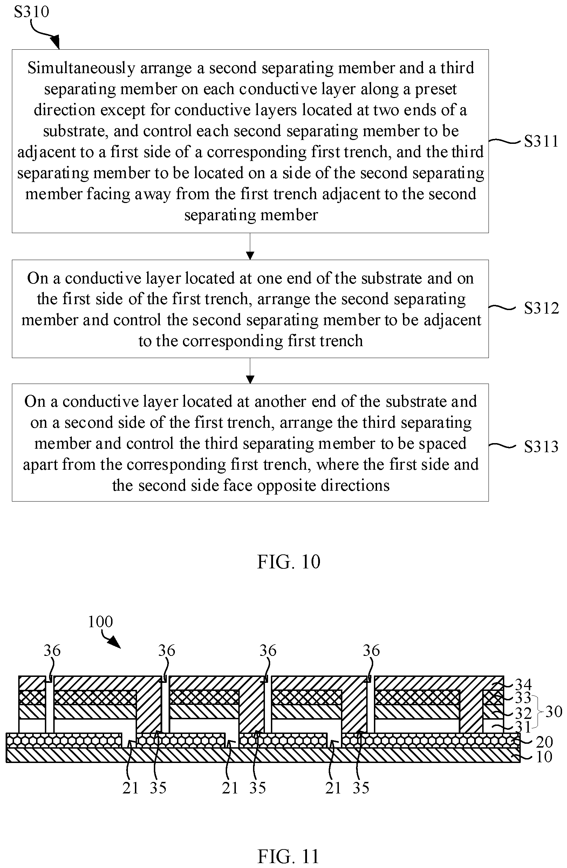

According to some embodiments of this application, referring to FIG. 10, the step S310 of simultaneously arranging the second separating member 22a and the third separating member 22b, which are attached to each other, on a side of each of at least part of the conductive layers 20 facing away from the substrate 10 includes:
S311: Simultaneously arrange the second separating member 22a and the third separating member 22b on each conductive layer 20 along the preset direction X except for conductive layers 20 located at two ends of the substrate 10, and control each second separating member 22a to be adjacent to a first side of a corresponding first trench 21, and the third separating member 22b to be located on a side of the second separating member 22a facing away from the first trench 21 adjacent to the second separating member 22a.

In step S311, the second separating member 22a and the third separating member 22b are simultaneously arranged on all the conductive layers 20 in the middle part, ensuring that the formed functional layer groups 30 are disconnected, and that each electrode layer 34 can come into contact with the corresponding conductive layer 20. Refer to FIG. 2 for details.

Each second separating member 22a is adjacent to a first side of a position of the first trench 21, which means that each second separating member 22a is arranged close to the position of the first trench 21 and is located on a same side of the first trench 21. For example, each second separating member 22a is arranged next to the right side of the first trench 21; or each second separating member 22a is arranged next to the left side of the first trench 21.

The positional relationship between the second separating member 22a and the third separating member 22b may be, for example, in close contact with each other or with a certain gap between them. Attached to each other should be understood as: the third separating member 22b is attached to a side surface of the second separating member 22a facing away from an adjacent second separating member 22a.

Such design ensures that the functional layer groups 30 in the middle part meet the structural forming requirements, making the solar cell assembly 100 have good voltage and current output.

According to some embodiments of this application, a distance between the second separating member 22a and the adjacent first trench 21 is denoted as D, satisfying 0 µm < D ≤ 20 µm.

It is advantageous to keep the distance between the second separating member 22a and the adjacent first trench 21 as small as possible. If the distance D between the two is 0, one side of the formed semiconductor layer 32 will be flush with one side of the adjacent conductive layer 20, but this requires a high alignment precision and is difficult to operate. If the distance D is too large, the functional layer group 30 may take up too much space on another conductive layer 20.

The value of distance D may range from 0 µm to 20 µm, for example, the distance D may be, but is not limited to, 1 µm, 1 µm, 5 µm, 10 µm, 15 µm, 20 µm, and the like.

Controlling the distance between the second separating member 22a and the adjacent first trench 21 within a reasonable range is conducive to obtaining a more reasonable structure and more stable performance of the assembly.

According to some embodiments of this application, still referring to FIG. 10, the step S310 of simultaneously arranging the second separating member 22a and the third separating member 22b, which are attached to each other, on a side of each of at least part of the conductive layers 20 facing away from the substrate 10 further includes:
S312: On a conductive layer 20 located at one end of the substrate 10 and on a first side of the first trench 21, arrange the second separating member 22a and control the second separating member 22a to be adjacent to the corresponding first trench 21; and
S313: On a conductive layer 20 located at another end of the substrate 10 and on a second side of the first trench 21, arrange the third separating member 22b and control the third separating member 22b to be spaced apart from the corresponding first trench 21, where the first side and the second side face opposite directions.

In step S312 and step S313, on the conductive layers 20 located at two ends, one is arranged with only the second separating member 22a, and the other is arranged with only the third separating member 22b; and the remaining conductive layers 20 are each simultaneously arranged with the second separating member 22a and the third separating member 22b. Such design allows a sub-cell of the same specifications to be separated on one end of the conductive layer 20, while the semiconductor layer 32 on the other end of the conductive layer 20 is cut off, making the electrode layer 34 come into contact with the conductive layer 20. Refer to FIG. 11.

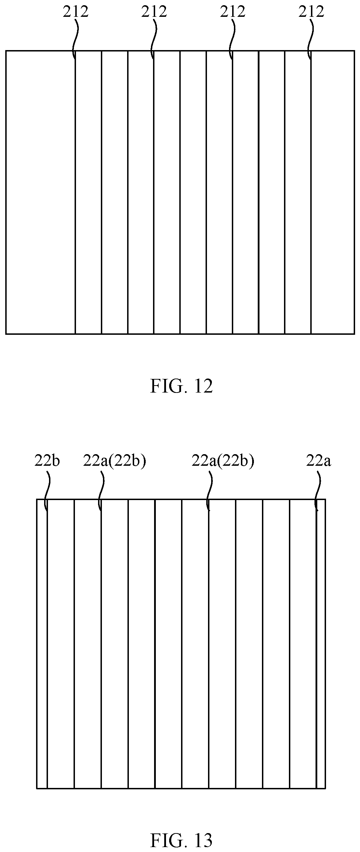

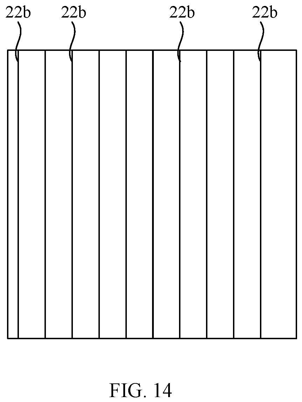

For ease of understanding, an example with 10 sub-cells is used for illustration. However, it should be noted that this should not be interpreted as limiting the scope of the solution of this application. During the preparation of the conductive layer 20, 10 first separating members 212 are arranged at intervals on the substrate 10 from left to right, leaving at least the width of one sub-cell between the first first separating member 212 and a left edge, for example, 1.6 cm. Refer to FIG. 12. After the conductive layer 20 is formed, the second separating member 22a and the third separating member 22b are sequentially arranged adjacent to the right side of the position of the first separating member 212. The right side of the position of the last first separating member 212 is arranged with only the second separating member 22a. At the same time, the leftmost conductive layer 20 is arranged with only the third separating member 22b. A distance between the third separating member 22b and the adjacent second separating member 22a is the width of one sub-cell, for example, 0.6 cm, and the like. Refer to FIG. 13. After the arrangement is completed, the first transport layer 31, the semiconductor layer 32 (such as a perovskite layer, and the like), and the second transport layer 33 are sequentially deposited (for example, by evaporation, and the like). After the deposition is completed, the second separating member 22a is removed, and the third separating member 22b is either retained or updated. The electrode layer 34 is then deposited on one side of the second transport layer 33, forming several functional layer groups 30. Refer to FIG. 14. Finally, the third separating member 22b is removed.

Such design ensures that the specifications of the sub-cell at one end meet the design requirements while also ensuring that the electrode layer 34 of the sub-cell at the other end gets in contact with the conductive layer 20, making the structure and performance of the solar cell assembly 100 more stable.

According to some embodiments of this application, referring to FIG. 7, the step S400 of sequentially stacking and depositing a first transport layer 31, a semiconductor layer 32, and a second transport layer 33 on at least one side of the isolation body 222 along the preset direction X includes:
S410: Sequentially deposit the first transport layer 31, the semiconductor layer 32, and the second transport layer 33 on the side of the conductive layer 20 facing away from the substrate 10 in a vacuum environment.

Depositing the first transport layer 31, the semiconductor layer 32, and the second transport layer 33 in a vacuum environment helps avoid the impact of water and oxygen on the performance of the assembly. In addition, there are various deposition methods, such as evaporation, sputtering, vapor transport method, close-space sublimation method, and the like.

Thus, depositing the first transport layer 31, the semiconductor layer 32, and the second transport layer 33 on the side of the conductive layer 20 facing away from the substrate 10 in a vacuum environment makes the obtained assembly performance better. In addition, by utilizing the second separating member 22a and the third separating member 22b, disconnected semiconductor layers 32 are automatically obtained without the need for subsequent laser or mechanical scribing.

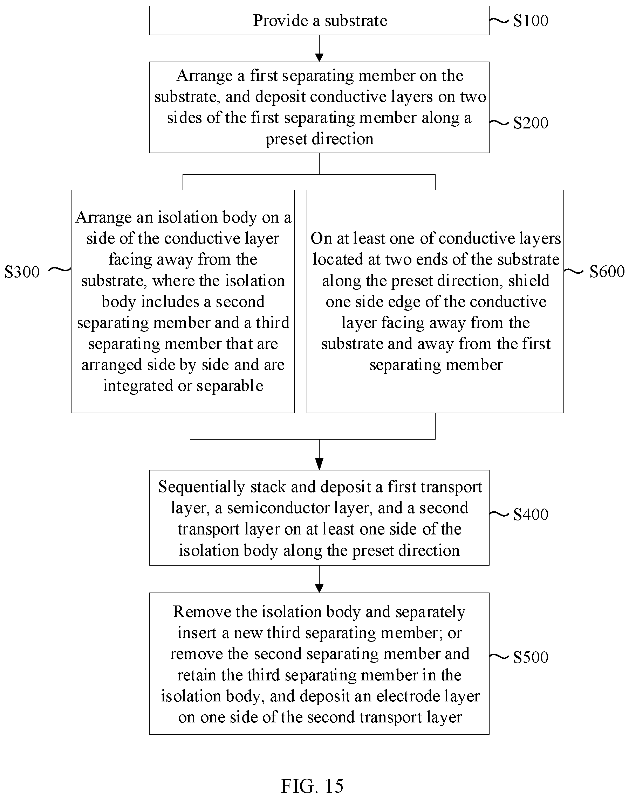

According to some embodiments of this application, referring to FIG. 15, before the step S300 of sequentially stacking and depositing a first transport layer 31, a semiconductor layer 32, and a second transport layer 33 on at least one side of the isolation body 222 along the preset direction X, the method further includes:
S600: On at least one of conductive layers 20 located at two ends of the substrate 10 along the preset direction X, shield one side edge of the conductive layer 20 facing away from the substrate 10 and away from the first separating member 212.

The execution order of step S600 and step S300 is not specifically required. For example, in the preparation process, step S300 can be executed first, followed by step S600; step S600 can be executed first, followed by step S300; or steps S300 and S600 can be executed simultaneously, for example, through integrating the shielding structure, the second separating member 22a, and the third separating member 22b in the same mold, and the like.

When a part of one side surface of the conductive layer 20 near one end of the substrate 10 is shielded, no excess functional layer group 30 can be deposited on that part, eliminating the need for subsequent edge cleaning processes. In specific embodiments, after the conductive layer 20 is formed, two shielding members 224 are respectively arranged on the conductive layers 20 at two ends of the substrate 10, with the shielding members 224 respectively arranged near the two ends of the substrate 10.

Thus, before depositing the functional layer group 30, shielding one side edge of the conductive layer 20 near one end of the substrate 10 for each of the two ends avoids the deposition of the functional layer group 30 on the edge, thereby avoiding the subsequent edge cleaning process.

According to some embodiments of this application, thickness of the second separating member 22a and thickness of the third separating member 22b along the preset direction X both range from 50 µm to 200 µm.

The thickness of the second separating member 22a and the thickness of the third separating member 22b each may be a value ranging from 50 µm to 200 µm. For example, the thickness of the first separating member 212, the thickness of the second separating member 22a, and the thickness of the third separating member 22b each may be, but is not limited to, 50 µm, 60 µm, 70 µm, 80 µm, 90 µm, 100 µm, 150 µm, 200 µm, and the like. Of course, the thickness of the first separating member 212 may also range from 50 µm to 200 µm.

Reasonably controlling the thickness of the second separating member 22a and the thickness of the third separating member 22b is conducive to obtaining first trenches 21, second trenches 35, and third trenches 36 of reasonable thickness, avoiding excessively wide trenches that reduce the effective working area of the assembly.

According to some embodiments of this application, the semiconductor layer 32 is a perovskite layer.

A perovskite layer refers to a layer structure with a perovskite material, where the perovskite material is a type of material having the same crystal structure as calcium titanate (CaTiO3). Its structural formula is usually ABX3, where A and B are two types of cations, and X is an anion.

Thus, by using the preparation method of this application, a perovskite cell assembly can be prepared quickly and effectively, and additionally, this is conducive to improving the yield rate of the perovskite cell assembly.

According to some embodiments of this application, referring to FIG. 2, this application provides a solar cell assembly 100, prepared by using the preparation method of the solar cell assembly 100 in any of the foregoing solutions.

According to some embodiments of this application, this application provides a battery, including the solar cell assembly 100 in the foregoing solutions.

According to some embodiments of this application, referring to FIG. 3, FIG. 5, and FIG. 9, this application provides a preparation tooling 200, applied to the preparation method of a solar cell assembly 100 according to any one of the foregoing solutions. The preparation tooling 200 includes: a first auxiliary mechanism 210, a second auxiliary mechanism 220, and a third auxiliary mechanism 230. The first auxiliary mechanism 210 includes several first separating members 212 penetrating through a first frame body 214 having a first cavity 211 and arranged in parallel at intervals in the first cavity 211. A second auxiliary mechanism 220 includes several isolation bodies 222 penetrating through a second frame body 225 having a second cavity 221 and arranged in parallel at intervals in the first cavity 211, the isolation bodies 222 being configured to be respectively located on same sides of their corresponding first separating members 212, where the isolation body 222 includes a second separating member 22a and a third separating member 22b arranged side by side. A third auxiliary mechanism 230 includes several third separating members 22b penetrating through a third frame body 232 having a third cavity 231 and arranged in parallel at intervals in the third cavity 231, distribution positions of the third separating members 22b in the third cavity 231 being consistent with distribution positions of the third separating members 22b in the second cavity 221.

The first cavity 211 is designed to be fixed with several first separating members 212 and allow material to be deposited on the substrate 10, and the first cavity 211 is arranged penetrating through the first frame body 214. Several first separating members 212 are arranged in parallel at intervals in the first frame body 214, dividing the first cavity 211 into multiple first gaps 215, where the first gaps 215 allow materials to be deposited on the substrate 10 to form the conductive layers 20.

The second cavity 221 is designed to be fixed with several second separating members 22a and third separating members 22b and allow materials to be deposited on the conductive layers 20. Similarly, the second cavity 221 is arranged penetrating through the second frame body 225. Several second separating members 22a and third separating members 22b are arranged in parallel at intervals in the second frame body 225 with each second separating member 22a and the corresponding third separating member 22b as an entirety, dividing the second cavity 221 into multiple second gaps 226, where the second gaps 226 allow materials to be deposited on the conductive layers 20 to sequentially form the first transport layers 31, the semiconductor layers 32, and the second transport layers 33. In some embodiments, a size of the second cavity 221 should be consistent with a size of the first cavity 211, so that in the preparation of the solar cell assembly 100, the operation space for the deposition processes before and after remains consistent, which is conducive to ensuring the structural precision of the assembly.

The isolation bodies 222 are configured to be respectively located on the same sides of their corresponding first separating members 212, that is, each isolation body 222 can be adjusted to be located on one side of the first separating member 212, so that the obtained second trenches 35 or third trenches 36 are kept on one side of the first trench 21, making the obtained sub-cells be connected in series.

In the second auxiliary mechanism 220, the second separating member 22a and the third separating member 22b may be designed as separate structures. This allows the second separating member 22a to be removed from the second frame body 225, and the third separating member 22b to be retained separately, so that the third auxiliary mechanism 230 is not required to be used additionally in the subsequent preparation of the electrode layers 34. In addition, the second separating member 22a and the third separating member 22b may be arranged in a way, for example, closely attached or kept at a certain gap. Of course, in the second auxiliary mechanism 220, the second separating member 22a and the third separating member 22b may be designed as an integrated structure.

The third auxiliary mechanism 230 includes several third separating members 22b, and the distribution positions of the third separating members 22b in the third cavity 231 are consistent with the distribution positions of the third separating members 22b in the second cavity 221, so that when the semiconductor layer 32 and the transport layer deposition are completed, during the operation with the third auxiliary mechanism 230, the third separating members 22b in the third auxiliary mechanism 230 can be kept in the original positions of the third separating members 22b in the second auxiliary mechanism 220, ensuring that the deposition of the electrode layers 34 do not deviate. In addition, several third separating members 22b are arranged in parallel at intervals in the third frame body 231, forming multiple third gaps 233, where the third gaps 233 allow materials to be deposited on the second transport layers 33 to form the electrode layers 34. In addition, the number of third separating members 22b in the third auxiliary mechanism 230 is consistent with the number of third separating members 22b in the second auxiliary mechanism 220.

In some embodiments, the first auxiliary mechanism 210, the second auxiliary mechanism 220, and the third auxiliary mechanism 230 can share one frame body. In other words, the first frame body 214, the second frame body 225, and the third frame body 232 are of a same structure. After the conductive layers 20 are completed, the first separating members 212 can be removed, and the isolation body 222 or the third separating member 22b, and the like can be fitted.

When the foregoing preparation tooling 200 is used during the preparation of the conductive layers 20, the substrate 10 is placed in the first cavity 211, so that several first separating members 212 are distributed at intervals on the substrate 10, ensuring that the conductive layers 20 are disconnected during the forming process, avoiding the need for laser or other tools for scribing after the forming process. After the conductive layers 20 are formed, the substrate 10 with the conductive layers 20 is placed in the second cavity 221, so that the isolation bodies 222 are distributed at intervals on one side of the conductive layers 20, making functional layer groups 30 formed on one side of the conductive layer 20 be separated on two sides of the third separating members 22b. In addition, the space occupied by the second separating member 22a on the conductive layer 20 allows the functional layer group 30 to come into contact with the conductive layer 20 through this space, thereby achieving the series connection of different functional layer groups 30. Thus, the issue of traditional scribing being too shallow or too deep, which leads to increased series resistance, is effectively addressed, ensuring the stable performance of the solar cell assembly 100.

According to some embodiments of this application, referring to FIG. 3, the first auxiliary mechanism 210 further includes two first supporting members 213 spaced apart in the first cavity 211, each first separating member 212 connecting the two first supporting members 213.

The first supporting member 213 refers to a structure that provides support for fixing the first separating member 212. There are various methods to fix the first supporting member 213 in the first cavity 211. For example, the fixing method may be, but is not limited to, bolt connection, welding, snap-fit, magnetic attraction, riveting, integrated molding, and the like. Similarly, the connection between the first supporting member 213 and the first separating member 212 may be a detachable connection, for example, bolt connection, snap-fit, magnetic attraction, and the like, and it may also be a non-detachable connection, for example, welding, integrated molding, and the like.

The arrangement of the two first supporting members 213 enables the fixation of the first separating member 212 more stable, which is conducive to improving the precision of the deposition of the conductive layer 20.

According to some embodiments of this application, the first separating member 212, the second separating member 22a, and the third separating member 22b are all configured as a flat structure, and a flat surface of the first separating member 212 is parallel to a penetration direction of the first cavity 211, a flat surface of the second separating member 22a is parallel to a penetration direction of the second cavity 221, and a flat surface of the third separating member 22b is parallel to a penetration direction of the second cavity 221 or the third cavity 231.

A flat structure refers to a structure having a thickness less than at least one dimension of a flat surface of the structure. For example, the thickness of the structure is less than a length of the flat surface, or the thickness of the structure is less than a width of the flat surface. Here, the flat surface is a side surface of the structure along its thickness direction. In some embodiments, when the first separating member 212, the second separating member 22a, and the third separating member 22b are all configured as a flat structure, their respective thicknesses can be controlled within 50 µm to 200 µm.

The flat surface of the first separating member 212 is parallel to the penetration direction of the first cavity 211, the flat surface of the second separating member 22a is parallel to the penetration direction of the second cavity 221, and the flat surface of the third separating member 22b is parallel to the penetration direction of the second cavity 221 or the third cavity 231. This indicates that the first separating member 212, the second separating member 22a, and the third separating member 22b are vertically placed in their respective cavities, in other words, their respective flat surfaces are erected in parallel in their corresponding cavities.

Designing the first separating member 212, the second separating member 22a, and the third separating member 22b as flat reduces the space occupied by their respective thicknesses in the corresponding cavities, avoiding a reduction of the effective working area of the assembly.

According to some embodiments of this application, when the second frame body 225 is stacked on the first frame body 214, as to the isolation body 222 and a corresponding first separating member 212, the second separating member 22a is located between the first separating member 212 and the third separating member 22b, and a distance between the second separating member 22a and the corresponding first separating member 212 is denoted as D, satisfying 0 µm < D ≤ 20 µm.

When the second frame body 225 is stacked on the first frame body 214, the isolation bodies 222 are respectively located on the same sides of the first separating members 212, for example, are all located on the left sides, the right side, or the like of the first separating member 212. It should be noted here that in the preparation of the assembly, a scenario that the first frame body 214 and the second frame body 225 are stacked will not occur, because after the conductive layer 20 is prepared, the first frame body 214 will be removed. Here, the purpose of defining the second frame body 225 to be stacked on the first frame body 214 is to ensure that when the first frame body 214 is removed and the second frame body 225 is used, the isolation body 222 is exactly on a same side as the previous position of the first separating member 212.

The second separating member 22a is located between the third separating member 22b and the first separating member 212. The purpose is that when the second separating member 22a is removed, the formed second trench 35 is located between the semiconductor layer 32 and the third separating member 22b, so that the subsequently formed electrode layer 34 gets in contact with the conductive layer 20 through the position of the second trench 35. If the third separating member 22b is located between the second separating member 22a and the first separating member 212, during the subsequent deposition of the electrode layer 20, the electrode layer 20 may easily be separated by the third separating member 22b, making it impossible to achieve series connection between sub-cells.

Reasonably controlling the distribution positions of the first separating member 212, the second separating member 22a, and the third separating member 22b is conducive to obtaining a more reasonable structure and more stable performance of the assembly.

According to some embodiments of this application, referring to FIG. 3, the first supporting member 213 is located in the first cavity 211, forming a first groove between the first supporting member 213 and the cavity wall of the first cavity 211, where the first groove is used for placing the substrate 10.

The first supporting member 213 is located in the first cavity 211, that is, one side surface of the first supporting member 213 is lower than one end of the first cavity 211, thus forming the first groove, which facilitates the fixation of the substrate 10 and the deposition of the conductive layer 20.

Such design makes the fixation of the substrate 10 more convenient, thereby making the deposition of the conductive layer 20 more stable.

According to some embodiments of this application, referring to FIG. 5, the second auxiliary mechanism 220 further includes two second supporting members 223 spaced apart in the second cavity 221, each second separating member 22a connecting the two second supporting members 223.

The second supporting member 223 refers to a structure that provides support for fixing the second separating member 22a. There are various methods to fix the second supporting member 223 in the second cavity 221. For example, the fixing method may be, but is not limited to, bolt connection, welding, snap-fit, magnetic attraction, riveting, integrated molding, and the like. Similarly, the connection between the second supporting member 223 and the second separating member 22a may be a detachable connection, for example, bolt connection, snap-fit, magnetic attraction, and the like, and it may also be a non-detachable connection, for example, welding, integrated molding, and the like.

The arrangement of the two second supporting members 223 enables the fixation of the second separating member 22a more stable, which is conducive to improving the precision of the deposition of the functional layer group 30.

According to some embodiments of this application, referring to FIG. 5, the second supporting member 223 is located in the second cavity 221, forming a second groove between the second supporting member 223 and the cavity wall of the second cavity 221, where the second groove is used for placing the substrate 10 with the conductive layers 20.

The second supporting member 223 is located in the second cavity 221, that is, one side surface of the second supporting member 223 is lower than one end of the second cavity 221, thus forming the second groove, which facilitates the fixation of the substrate 10 and the deposition of the functional layer group 30.

Such design makes the fixation of the substrate 10 with the conductive layers 20 more convenient, thereby making the deposition of the functional layer group 30 more stable.

According to some embodiments of this application, referring to FIG. 5, the second auxiliary mechanism 220 further includes two shielding members 224 which are spaced apart and connect the two second supporting members 223. The two shielding members 224 are located on two sides of all the isolation bodies 222 and are respectively fitted with inner walls of the second cavity 221.

The shielding member 224 refers to a structure that can prevent part of the functional layer group 30 from being deposited on two ends of the substrate 10. It can also be arranged in the third auxiliary mechanism 230. Refer to FIG. 9.

There are various methods to connect the shielding member 224 to the second supporting member 223. For example, the connection method may be, but is not limited to, bolt connection, welding, snap-fit, magnetic attraction, riveting, integrated molding, and the like.

Arranging the shielding members 224 respectively on two sides of the isolation bodies 222 is conducive to shielding the deposition of the functional layer group 30 on the edges, avoiding deposition on two ends of the substrate 10 that would require subsequent edge cleaning processes.

According to some embodiments of this application, referring to FIG. 5, the second auxiliary mechanism 220 further includes a separate second separating member 22a and a separate third separating member 22b. The separate second separating member 22a and the separate third separating member 22b are respectively located on two opposite sides of all the isolation bodies 222.

Arranging a separate second separating member 22a and a separate third separating member 22b on two sides respectively allows a sub-cell of the same specifications to be separated on one end of the conductive layer 20, while the semiconductor layer 32 on the other end of the conductive layer 20 is cut off, making the electrode layer 34 come into contact with the conductive layer 20.

Such design is conducive to ensure that the specifications of the sub-cell at one end meet the design requirements while also ensuring that the electrode layer 34 of the sub-cell at the other end gets in contact with the conductive layer 20, making the structure and performance of the solar cell assembly 100 more stable.

According to some embodiments of this application, referring to FIG. 1 to FIG. 15, this application provides a preparation method of a solar cell assembly 100, where the solar cell assembly 100 may be a perovskite assembly. A first auxiliary mechanism 210 is designed, in which several first separating members 212 are arranged at intervals. During the preparation of the conductive layer 20, the substrate 10 is placed into the first auxiliary mechanism 210, and the conductive layers 20 are deposited on the substrate 10 by utilizing the first separating members 212. A second auxiliary mechanism 220 is designed, in which several second separating members 22a and third separating members 22b are arranged at intervals, with each second separating member 22a positioned on a same side of the first separating member 212. After the conductive layers 20 are deposited, the substrate 10 with the conductive layers 20 is placed into the second auxiliary mechanism 220. The first transport layers 31, semiconductor layers 32, and second transport layers 33 are deposited on the conductive layers 20 by utilizing the second separating members 22a and third separating members 22b. Finally, a third auxiliary mechanism 230 is designed, in which several third separating members 22b are arranged at intervals. The electrode layers 34 are deposited on the second transport layers 33 by utilizing the third separating members 22b, thus completing the preparation of the solar cell assembly 100.

In conclusion, it should be noted that the above embodiments are merely intended for describing the technical solutions of this application but not for limiting this application. Although this application is described in detail with reference to the foregoing embodiments, persons of ordinary skill in the art should understand that they may still make modifications to the technical solutions described in the foregoing embodiments or make equivalent replacements to some or all technical features thereof without departing from the scope of the technical solutions of the embodiments of this application. They should all be covered in the scope of the claims and specification of this application. In particular, as long as there is no structural conflict, the various technical features mentioned in the embodiments can be combined in any manner. This application is not limited to the specific embodiments disclosed in this specification but includes all technical solutions falling within the scope of the claims.

## Claims

1. A method for preparing a solar cell assembly (100), comprising the following steps:
providing a substrate (10);
forming conductive layers (20) on the substrate (10) separated by a first trench (21) along a preset direction (X);
arranging an isolation body (222) on a side of the conductive layer (20) facing away from the substrate (10), wherein the isolation body (222) comprises a second separating member (22a) and a third separating member (22b) that are arranged side by side and are integrated or separable;
sequentially stacking and depositing a first transport layer (31), a semiconductor layer (32), and a second transport layer (33) on at least one side of the isolation body (222) along the preset direction (X); and
removing the isolation body (222) and separately inserting a new third separating member (22b); or removing the second separating member (22a) and retaining the third separating member (22b) in the isolation body (222), and depositing an electrode layer (34) on one side of the second transport layer (33).

2. The method for preparing a solar cell assembly (100) according to claim 1, wherein the step of forming conductive layers (20) on the substrate (10) separated by a first trench (21) along a preset direction (X) comprises:
arranging a first separating member (212) on the substrate (10), and depositing on two sides of the first separating member (212) along the preset direction (X) to form conductive layers (20) separated by the first trench (21).

3. The method for preparing a solar cell assembly (100) according to claim 2, wherein the step of arranging a first separating member (212) on the substrate (10), and depositing on two sides of the first separating member (212) along the preset direction (X) to form conductive layers (20) separated by the first trench (21) comprises:
arranging several first separating members (212) at intervals on the substrate (10) along the preset direction (X);
sputtering on a side surface of the substrate (10) facing the first separating members (212) in a vacuum environment; and
removing the first separating members (212) to leave first trenches (21) on the substrate (10), thereby forming several conductive layers (20).

4. The method for preparing a solar cell assembly (100) according to claim 1, wherein the step of arranging an isolation body (222) on a side of the conductive layer (20) facing away from the substrate (10) comprises:
simultaneously arranging the second separating member (22a) and the third separating member (22b), which are attached to each other, on a side of each of at least part of the conductive layers (20) facing away from the substrate (10).

5. The method for preparing a solar cell assembly (100) according to claim 4, wherein the step of simultaneously arranging the second separating member (22a) and the third separating member (22b), which are attached to each other, on a side of each of at least part of the conductive layers (20) facing away from the substrate (10) comprises:
simultaneously arranging the second separating member (22a) and the third separating member (22b) on each conductive layer (20) along the preset direction (X) except for conductive layers (20) located at two ends of the substrate (10); and controlling each second separating member (22a) to be adjacent to a first side of a corresponding first trench (21), and the third separating member (22b) to be located on a side of the second separating member (22a) facing away from the first trench (21) adjacent to the second separating member (22a).

6. The method for preparing a solar cell assembly (100) according to claim 5, wherein a distance between the second separating member (22a) and the adjacent first trench (21) is denoted as D, satisfying 0 µm < D ≤ 20 µm.

7. The method for preparing a solar cell assembly (100) according to claim 5, wherein the step of simultaneously arranging the second separating member (22a) and the third separating member (22b), which are attached to each other, on a side of each of at least part of the conductive layers (20) facing away from the substrate (10) further comprises:
on a conductive layer (20) located at one end of the substrate (10) and on a first side of the first trench (21), arranging the second separating member (22a) and controlling the second separating member (22a) to be adjacent to the corresponding first trench (21); and
on a conductive layer (20) located at another end of the substrate (10) and on a second side of the first trench (21), arranging the third separating member (22b) and controlling the third separating member (22b) to be spaced apart from the corresponding first trench (21), wherein the first side and the second side face opposite directions.

8. The method for preparing a solar cell assembly (100) according to any one of claims 1 to 7, wherein the step of sequentially stacking and depositing a first transport layer (31), a semiconductor layer (32), and a second transport layer (33) on at least one side of the isolation body (222) along the preset direction (X) comprises:
sequentially depositing the first transport layer (31), the semiconductor layer (32), and the second transport layer (33) on the side of the conductive layer (20) facing away from the substrate (10) in a vacuum environment.

9. The method for preparing a solar cell assembly (100) according to any one of claims 1 to 8, before the step of sequentially stacking and depositing a first transport layer (31), a semiconductor layer (32), and a second transport layer (33) on at least one side of the isolation body (222) along the preset direction (X), further comprising:
on at least one of conductive layers (20) located at two ends of the substrate (10) along the preset direction (X), shielding one side edge of the conductive layer (20) facing away from the substrate (10) and away from the first trench (21).

10. The method for preparing a solar cell assembly (100) according to any one of claims 1 to 9, wherein thickness of the second separating member (22a) and thickness of the third separating member (22b) along the preset direction (X) each range from 50 µm to 200 µm.

11. The method for preparing a solar cell assembly (100) according to any one of claims 1 to 10, wherein the semiconductor layer (32) is a perovskite layer.

12. A solar cell assembly (100), prepared by the method for preparing a solar cell assembly (100) according to any one of claims 1 to 11.

13. A battery, comprising the solar cell assembly (100) according to claim 12.

14. A preparation tooling (200), applied to the method for preparing a solar cell assembly (100) according to any one of claims 1 to 11, comprising:
a first auxiliary mechanism (210), comprising several first separating members (212) that penetrate through a first frame body (214) having a first cavity (211) and are arranged in parallel at intervals in the first cavity (211);
a second auxiliary mechanism (220), comprising several isolation bodies (222) that penetrate through a second frame body (225) having a second cavity (221) and are arranged in parallel at intervals in the second cavity (221), the isolation bodies (222) configured to be respectively located on same sides of their corresponding first separating members (212), wherein the isolation body (222) comprises a second separating member (22a) and a third separating member (22b) arranged side by side; and
a third auxiliary mechanism (230), comprising several third separating members (22b) that penetrate through a third frame body (232) having a third cavity (231) and are arranged in parallel at intervals in the third cavity (231), distribution positions of the third separating members (22b) in the third cavity (231) being consistent with distribution positions of the third separating members (22b) in the second cavity (221).

15. The preparation tooling (200) according to claim 14, wherein the first auxiliary mechanism (210) further comprises two first supporting members (213) spaced apart in the first cavity (211), each first separating member (212) connected between the two first supporting members (213).

16. The preparation tooling (200) according to claim 14 or claim 15, wherein the first separating member (212), the second separating member (22a), and the third separating member (22b) are all configured as a flat structure, and a flat surface of the first separating member (212) is parallel to a penetration direction of the first cavity (211), a flat surface of the second separating member (22a) is parallel to a penetration direction of the second cavity (221), and a flat surface of the third separating member (22b) is parallel to a penetration direction of the second cavity (221) or the third cavity (231).

17. The preparation tooling (200) according to any one of claims 14 to 16, wherein when the second frame body (225) is stacked on the first frame body (214), for the isolation body (222) and a corresponding first separating member (212), the second separating member (22a) is located between the first separating member (212) and the third separating member (22b), and a distance between the second separating member (22a) and the corresponding first separating member (212) is denoted as D, satisfying 0 µm < D ≤ 20 µm.

18. The preparation tooling (200) according to any one of claims 14 to 17, wherein the second auxiliary mechanism (220) further comprises two second supporting members (223) spaced apart in the second cavity (221), each second separating member (22a) connected between the two second supporting members (223).

19. The preparation tooling (200) according to claim 18, wherein the second auxiliary mechanism (220) further comprises two shielding members (224) which are spaced apart and connected between the two second supporting members (223), the two shielding members (224) located on two sides of all the isolation bodies (222) and respectively fitting with inner walls of the second cavity (221).

20. The preparation tooling (200) according to any one of claims 14 to 19, wherein the second auxiliary mechanism (220) further comprises a separate second separating member (22a) and a separate third separating member (22b), the separate second separating member (22a) and the separate third separating member (22b) respectively located on two opposite sides of all the isolation bodies (222).
